# EUROPEAN PATENT APPLICATION

(11) **EP 1 142 922 A2**
(43) Date of publication of application: **10.10.2001**
(21) Application number: 01104297.5
(22) Date of filing: 22.02.2001
(51) Int. Cl.: C08G 59/30, G03F 7/075

(54) **Photo-curable resin composition, process for producing the same and products using the same**

(30) Priority: 05.04.2000 JP 2000104031
(71) Applicant: Hitachi, Ltd., Chiyoda-ku, Tokyo 101-8010 (JP)
(72) Inventor: Suzuki, Masao, c/o Hitachi, Ltd., Intellectual, 1-chome, Chiyoda-ku, Tokyo 100-8220 (JP); Satsu, Yuichi, c/o Hitachi, Ltd., Int. Prop. Group, Chiyoda-ku, Tokyo 100-8220 (JP); Takahashi, Akio, c/o Hitachi, Ltd., Intellectual, 1-chome, Chiyoda-ku, Tokyo 100-8220 (JP); Nakai, Harukazu, c/o Hitachi, Ltd., Intellectual, 1-chome, Chiyoda-ku, Tokyo 100-8220 (JP); Ito, Yuzo, c/o Hitachi, Ltd., Int. Prop. Group, Chiyoda-ku, Tokyo 100-8220 (JP)
(74) Representative: Strehl Schübel-Hopf & Partner

(57) **Abstract**

The present photo-curable resin composition, at least one of which comprises an organic silicic compound, an epoxy resin and a photo initiator capable of polymerizing the organic silicic compound or epoxy resin upon absorption of actinic ray, undergoes polymerization and curing upon absorption of actinic ray, and is suitably applied to multilayered wiring boards and semiconductor devices because its cured product can maintain a desired modulus of elasticity at temperatures as high as or higher than Tg without any decrease in the bonding strength at elevated temperatures and with less development of cracks or peeling.

## Description

### BACKGROUND OF THE INVENTION

The present invention relates to a novel photo-curable resin composition, process for producing the same and multilayered wiring boards and semiconductor devices using the composition.

Photo-curable resin compositions have been so far widely utilized mainly in the electronics industry. In these years, its applications to semiconductors requiring fine interconnections or insulation layers, etc. in build-up type printed wiring boards have been positively studied. Cured products of these photo-curable resin compositions are usually composed mainly of organic materials and thus at elevated temperatures as high as or higher than the glass transition temperature (Tg), their moduli of elasticity are lower by at least one order and their coefficients of linear expansion are several times larger than at room temperature. Applications of photo-curable resin compositions to the aforementioned fields thus have the following problems.

For example, in case of photo-curable resin compositions used in build-up type printed wiring boards, LSI chips are surface-mounted on a wiring board through electrical connection at elevated temperatures as high as or higher than 200°C by wire bonding or CCB. Glass transition temperatures of the cured products of photo-curable resin compositions used for this purpose are usually 120° - 180°C. In that case, the insulation layers are usually softened during the mounting step, because the insulation layers reach a temperature as high as or higher than the glass transition temperature. Furthermore, no such reinforcing base materials as used in the ordinary printed wiring boards, for example, glass cloth, etc. can be used in the insulating layers in the aforementioned wiring boards, resulting in deformation of the wiring boards. Thus, when semiconductor devices are to be mounted thereon by wire bonding or CCB, the build-up type printed circuit boards will be deformed according to magnitutes of pressing forces, often resulting in electrical connection failures as a serious disadvantage. Furthermore, the photo-curable resin composition contains no such base materials and thus the cured products thereof have a high coefficient of thermal expansion, resulting in a wiring board warping problem, which is pronounced particularly when number of layers of photo-curable resin composition differs between the front side and the back side of a substrate. Due to these problems, connection reliability of mounted parts has been considerably lowered.

With advances of surface mounting technology, number of parts mounted on the aforementioned wiring board has been increased year by year, whereas the size of semiconductor package has been reduced. Thus, wafer level CSP (chip size package) is now popular. According to one of proposed CSP structures, insulating layers and electrodes are formed on the wiring on a wafer, and metal posts are formed to lessen the stress developed due to a difference in the coefficient of thermal expansion between the wiring board and the wafer, followed by forming solder balls each on heads of the metal posts to make connection to the substrate. In that case, the metal posts are formed by plating and thus a step of providing a patterned plating resist is required. Furthermore, to protect the metal posts after the removal of the patterned plating resist, a molding component for encapsulation having a high modulus of elasticity and a low coefficient of thermal expansion (which will be hereinafter referred to as "sealing resin") must be applied thereto by filling, and it has been heretofore necessary to expose the heads of metal posts by grinding after the application of the sealing resin.

To give a higher modulus of elasticity and a lower coefficient of thermal expansion to organic materials, on the other hand, it is the ordinary procedure to add an inorganic filler thereto, but such addition of an inorganic filler to ordinary photo-curable resin composition has such a problem of lowering of resolution due to light scattering and the resulting failure to form fine patterns.

To maintain the modulus of elasticity of organic materials while keeping the transparency thereof and further to suppress any increase in the coefficient of thermal expansion in a dispersion of fine inorganic materials in the organic materials, a method of condensing a metal alkoxide in organic materials by a sol-gel process has been proposed [Sumio Sakuhana : Application of Sol-Gel Process, published by Agne-Shofu, Ltd. (1997)]. Similar sol-gel process for photo-curable resin compositions susceptible to ultraviolet curing is disclosed in JP-A-5-202146 (= U.S.P. 5,629,358), JP-A-11-260148, etc.

Conventional sol-gel processes for photo-curable resin compositions include the following two types, i.e. a process for consecutively conducting polymerization of matrix and condensation of metal alkoxide and a process for simultaneously conducting the polymerization and condensation. Examples of the former process includes, for example, a process for conducting moisture curing of a silicon alkoxide at first and then conducting radical polymerization of matrix by a photo initiator capable of generating radicals upon light irradiation [P. Bosch et al : J. Polym. Sci. 34 3 289 (1996)] and a two-stage curing process for conducting the aforementioned curing steps in reversed order. The latter process includes a process using two kinds of photo initiators capable generating radicals and acid, respectively, or a single photo initiator capable of generating both radicals and acid (JP-A-11-260148).

In case of the former process, polymerization reaction of matrix proceeds in advance to condensation reaction of silicon alkoxide or the two reactions take place in reversed order consecutively, and thus the preceding reaction product inhibits materials for the successive reaction from movement, often resulting in remaining of unreacted portions in either silicon alkoxide or matrix, and thus it is hard to attain an effect of suppressing an increase in the coefficient of thermal expansion while maintaining a desired modulus of elasticity at elevated temperatures. In the latter process, the radical reaction usually proceeds earlier than the dehydrating condensation reaction of silicon alkoxide, resulting in disharmonious proceeding of reactions, suffering from the same problems as mentioned above.

In that case, shrinkage resulting from dehydrating reaction or generation of voids resulting from formation of water and alcohol will also cause serious defects in the products as a disadvantage. For the foregoing reasons, no resin compositions capable of producing cured products satisfying the requirements of maintaining a desired modulus of elasticity and a low coefficient of thermal expansion at elevated temperatures have been obtained yet.

In case of the aforementioned conventional processes, the viscosity is usually lowered due to the addition of silicon alkoxide of low molecular weight to the photo-curable resin composition. For example, in case of photo-curable resin composition for use in the build-up type printed wiring boards releasability from printing screen or light exposure mask will be deteriorated. In case of use in photo-curable film materials, releasability from the substrate film will be deteriorated. Thus, the silicon alkoxide has not been so far added sufficiently enough to fully increase the modulus of elasticity or lower the coefficient of thermal expansion at elevated temperatures.

Furthermore, a process comprising polycondensing only silicon alkoxide having organic residues at first, followed by mixing the polycondensate to a photo-curable resin composition has been proposed (JP-A-5-202146), where polymerization of silicon alkoxide having organic residues proceeds preferentially to form condensates of larger molecular units, resulting in not only an increase in the viscosity, but also inhibition of matrix resin from curing by the preferentially polymerized silicon alkoxide. Thus, no resin compositions capable of producing cured products satisfying the requirements of maintaining the desired modulus of elasticity and low coefficient of thermal expansion at elevated temperatures have been obtained yet.

In addition, JP-A 10-298405 (= U.S.P. 6,005,060) discloses a process comprising adding a silane alkoxide containing an epoxy group to an epoxy resin, followed by thermal curing. After the thermal curing, the glass transition temperature of the resin almost disappears to remarkably improve dynamic properties at high temperatures. But according to this process, since water is generated as a by-product at the time of curing, resulting in causing a problem of swelling at interface of a composite material. Further, according to this technology, there is no disclosure for imparting photo curable ability to the resin.

### BRIEF SUMMARY OF THE INVENTION

An object of the present invention is to provide a photo-curable resin composition capable of producing cured products which can maintain a desired modulus of elasticity at elevated temperatures as high as or higher than Tg, while keeping a small difference. The coefficient of thermal expansion between room temperature and elevated temperature without any decrease in the bonding strength at elevated temperatures and substantially without any consequential development of cracks or peeling, a process for producing the same, and multilayered wiring boards and semiconductor devices using the same.

The present invention provides a photo-curable resin composition capable of undergoing polymerization and curing upon absorption of actinic ray, at least one portion of the resin composition comprising an organic silicic compound represented by the following formula (1) or (2): 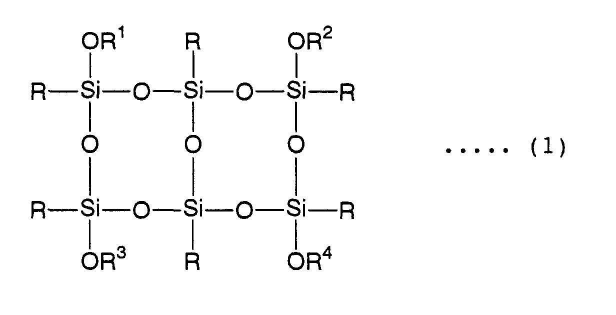 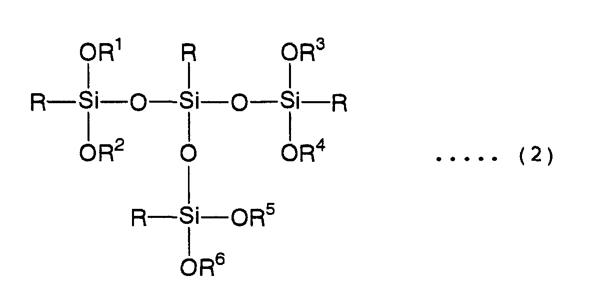 where R is an organic group reacting with an epoxy group; and R¹ to R⁶ are independently silicon-containing groups having 0-3 repeat units of (SiRO_{3/2}); in case the unit of (SiRO_{3/2}) is zero, R¹ to R⁶ are independently H, CH₃ or C₂H₆, an epoxy resin and a photo initiator capable of initiating polymerization of the organic silicic compound or the epoxy resin upon absorption of actinic ray, and a process for producing the same.

The present invention also provides products using the resin composition, e.g., multilayered wiring boards and semiconductor devices.

### BRIEF DESCRIPTION OF THE DRAWINGS

Figs. 1A-1G are cross-sectional views showing a flow of process steps for producing a wiring board according to Example 8.

Fig. 2 is a cross-sectional view showing a wiring board according to Example 8.

Figs. 3A-3F are cross-sectional views showing a flow of process steps for producing a wiring board according to Example 9.

Fig. 4 is a cross-sectional view showing a wiring board according to Example 9.

Fig. 5 is a cross-sectional view showing a semiconductor device according to Example 9.

Figs. 6A-6H are cross-sectional views showing a flow of process steps for producing a semiconductor device according to Example 10.

Fig. 7 is an enlarged cross-sectional view showing a semiconductor device of Fig. 6H.

### DETAILED DESCRIPTION OF THE INVENTION

As a result of extensive studies to solve the prior art problems while paying attention to the necessity that cured product of photo-curable resin composition must maintain a desired modulus of elasticity at elevated temperatures as high as or higher than the glass transition temperature (Tg) of cured products of photo-curable resin compositions so far used and a low coefficient of thermal expansion without any change in characteristics such as bonding strength, etc. at elevated temperature as high as or higher than Tg, the present inventors have attained the present invention. Furthermore, the present inventors have found that, so far as a plating resist can have similar characteristics to those of the resin composition, such steps as resist removal, sealing resin filling and its grinding can be made unnecessary.

The present photo-curable resin composition is a resin composition capable of undergoing polymerization and curing upon absorption of actinic ray, at least a portion of the resin composition comprising an organic silicic compound represented by the following formula (1) or (2): 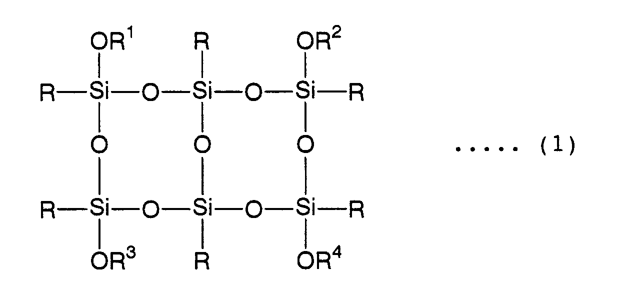 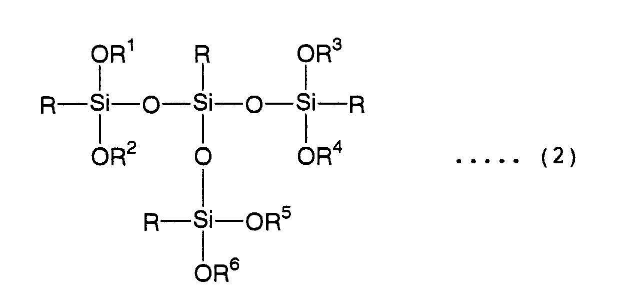 where R is an organic group reacting with an epoxy group; and R¹ to R⁶ are independently silicon-containing groups having 0-3 repeat units of (SiRO_{3/2}); in case the unit (SiRO_{3/2}) is zero, R¹ to R⁶ are independently H, CH₃ or C₂H₆, an epoxy resin and a photo initiator capable of initiating polymerization of the organic silicic compound or the epoxy resin upon absorption of actinic ray.

For the epoxy resin, any well known epoxy resin can be used without any particular restriction and includes, for example, bisphenol A type epoxy resin, bisphenol F type epoxy resin, novolak type epoxy resin, o-cresol novolak epoxy resin, m-cresol novolak type epoxy resin, alycidylamine type epoxy resin, alicyclic epoxy resin, etc. In case a highly transparent resin is required for the photo-curable resin, fluorine-containing epoxy resin and fluorine-containing acrylic resin can be effectively used. Epoxy acrylate resin or epoxy methacrylate resin obtained by acrylating or methacrylating portions of epoxy groups of the aforementioned epoxy resins by addition of propenoyl chloride or 2-methylpropenoyl chloride thereto can be also used. The aforementioned epoxy resins can be used alone or in mixture of at least two thereof.

The present photo-curable resin composition can be produced by a process comprising a step of heat treating a mixture comprising an epoxy resin, an organic silicic compound represented by the following formula (3): 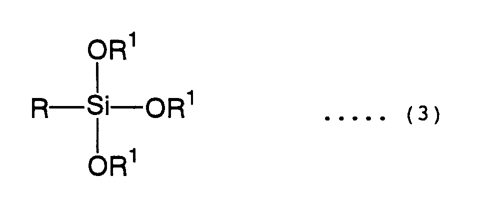 where R is an organic group reacting with either the aforementioned epoxy group or vinyl group; and R¹ is CH₃ or C₂H₅, and water at a temperature of preferably 60° - 160°C for 1-10 hours and a step of mixing a photo initiator with the heat-treated mixture.

Organic silicic compound represented by the foregoing formula (3) for use in the present invention includes, for example, organic silicic compounds having functional groups represented by the following formulae (4)-(11):

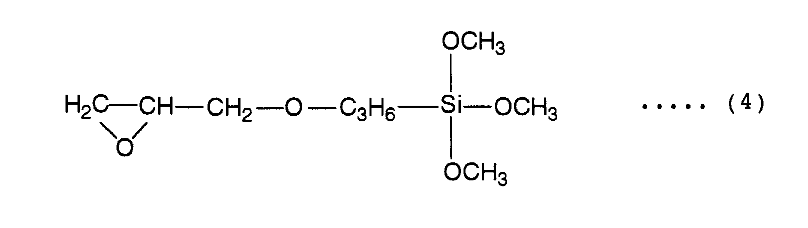

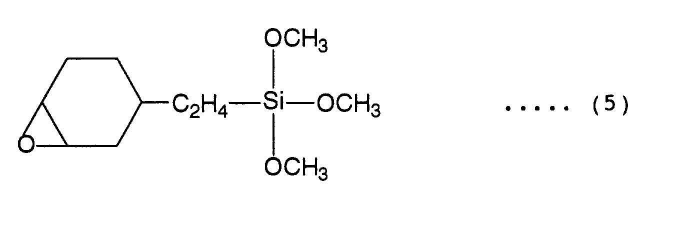

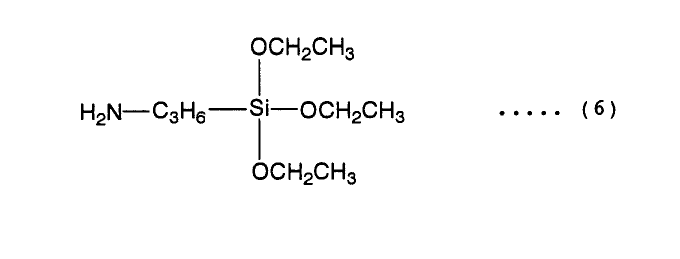

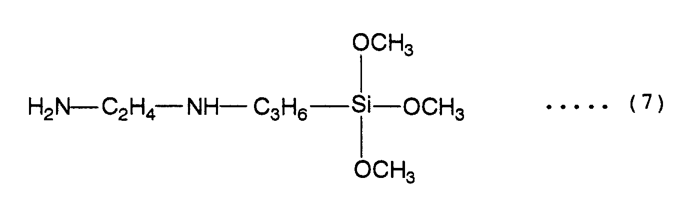

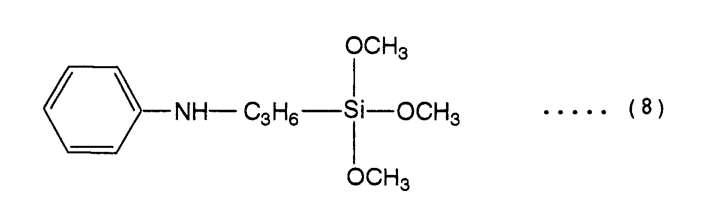

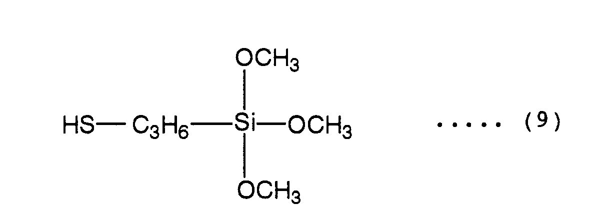

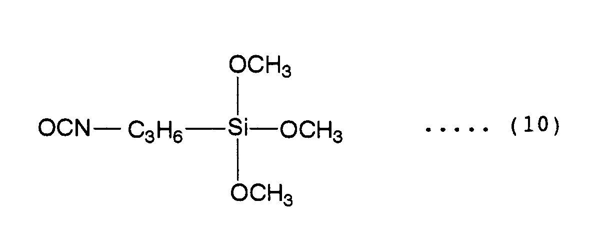

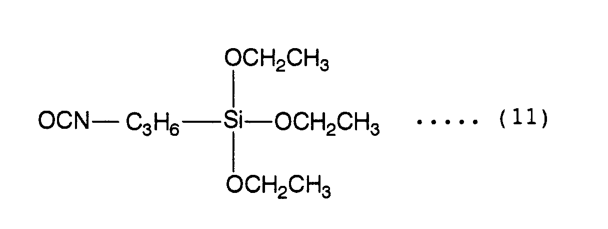

The organic silicic compound is not restricted to those as mentioned above and can be used alone or in combination at least two thereof.

In the present invention, a photo initiator capable of generating an acid or both radical and acid can be used upon proper selection in view of functional groups contained in the matrix resin or organic groups of organic silicic compound.

Acid generator includes onium salts such as diazonium salts, sulfonium salts, iodonium salts, etc. represented by ArN₂⁺Z⁻, (R)₃S⁺Z⁻, (R)₂I⁺Z⁻, etc. (where Ar is an aryl group; R is an aryl group or an alkyl group having 1-20 carbon atoms; and Z⁻ is an anion, e.g. BF₄⁻, PF₆⁻, AsF₆⁻ and SbF₆⁻) or organo-metallic compounds or the like, and specifically includes triallylsulfonium hexafluorophosphate, bis(4-diphenylsulfoniophenyl)sulfonium bishexafluorophosphate, (4-phenylthiophenyl)diphenylsulfonium hexafluorophosphate, p-benzoyldiphenyliodonium hexafluorophosphate, (4-methoxyphenyl)diphenylsulfonium hexafluoroautimonate, (4-methoxyphenyl)phenyliodonium hexafluoroantimonate, (2,4-cyclopentadiene-1-yl)[(1-methylethyl)benzene]-Fe-hexafluorophosphate, etc., but is not limited thereto.

As the photo initiator capable of generating both acid and radicals upon absorption of light, sulfonium salts and p-benzoyldiphenyliodonium hexafluorophosphate belonging to he aforementioned acid generator are known.

These compounds can be used alone or in mixture of at least two thereof.

Furthermore, the present photo-curable resin composition can be admixed with well known curing agents, curing accelerators, cross-linking agents, mold-releasing agents, defoaming agents, coupling agents, sensitizer, diluents, flame retardants, solvents, etc., depending on the purpose and uses.

To obtain cured products of photo-curable resin composition capable of maintaining a desired modulus of elasticity at temperatures as high as or higher than the glass transition temperature of matrix resin, while keeping a low coefficient of thermal expansion, the present inventors have found that heat treatment of a mixture of a matrix-constituting epoxy resin, an organic silicic compound and water in advance as such is effective. It seems that the heat treatment will give rise to condensation reaction of organic silicic compound in the resin, forming oligomer-sized molecules, and the resulting oligomers having an Si-O-Si skeleton will undergo dispersion at the nanometer level to react with the matrix-constituting epoxy resin, thereby easily developing dynamic characteristics.

Dispersibility of such an organic silicic compound oligomers can be confirmed by ²⁹Si-NMR chemical shift.

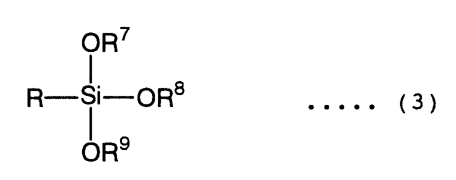

In case of ²⁹Si-NMR chemical shift of monomer of organic silicic compound of the foregoing formula (3), (where R is an organic group reacting with an epoxy group and R⁷, R⁸ and R⁹ are independently H, CH₃ or CH₂CH₃), absorption appears at -41 ppm to -44 ppm.

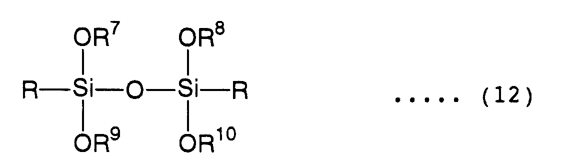

In case of ²⁹Si-NMR chemical shift of Si having one -O-Si bond as in an organic silicic compound of the foregoing formula (12) (where R is an organic group reacting with an epoxy group and R⁷ to R¹⁰ are independently H, CH₃, or CH₂CH₃) absorption appears at -48 ppm to -52 ppm.

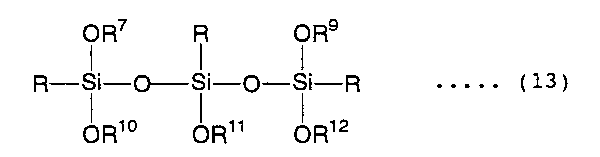

In case of ²⁹Si-MNR chemical shift of Si having two -O-Si bonds as in an organic silicic compound of the foregoing formula (13) (where R is an organic group reacting with an epoxy group; and R⁷, R⁹ to R¹² are independently H, CH₃ or CH₂CH₃) absorption appears at -53 ppm to -63 ppm.

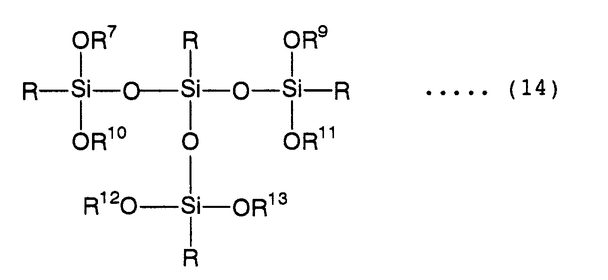

In case of ²⁹Si chemical shift of Si having three -O-Si bonds as in an organic silicic compound of the foregoing formula (14) (where R is an organic group reacting with an epoxy group; and R⁷, R⁹ to R¹³ are independently H, CH₃ or CH₂CH₃) absorption appears at -63 ppm to -72 ppm.

In measurement of ²⁹Si-NMR chemical shift of the present photo-curable resin composition, absorption appears at -40 ppm to -75 ppm. Integrated value of absorption at -53 ppm to -75 ppm is larger than that of absorption at -40 ppm to -52 ppm, and thus it is apparent that the silicon compounds in the cured product have Si-O-Si bonds and are approximately in an oligomer size. Even if the molecular weight of the silicon compound is increased, good dispersibility of the silicon compound can be maintained because there is the photo-curable resin as a compatible solvent to keep the resin transparent.

Cured products obtained from the photo-curable resin composition of the present invention show the following physical properties at 200°C to 225°C (Tg + 40°C):
Storage modulus of elasticity : 0.4 to 0.55 GPa
Bonding strength : 0.7 to 0.9 kN/m

The physical properties at room temperature (25°C) of the cured products mentioned above are as follows:
Storage modulus of elasticity : 2.2 to 1.8 GPa
Bonding strength : 1.5 to 1.3 kN/m

Differences between the physical properties at 200° to 225°C and at 25°C are as follows:
Difference in storage modulus of elasticity : -1.8 to -1.25 GPa
Difference in bonding strength : -0.8 to -0.4 kN/m

Products obtained by using the present photo-curable resin composition include, for example, multilayered wiring boards and semiconductor devices.

Multilayered wiring board comprises conductor layers, insulating layers composed of photo-curable resin composition and formed between the conductor layers and a filler filled in blind via holes interconnecting the conductor layers one to another, where at least one of the insulating layers is formed from a photo-curable resin composition, which comprises an organic silicic compound represented by the following general formula (1) or (2): 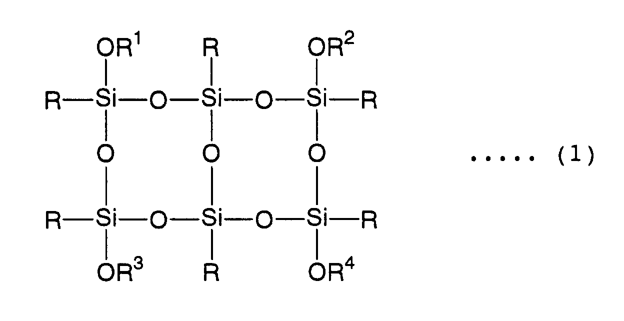 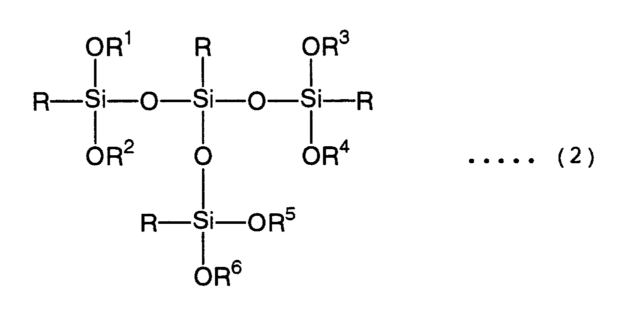 (where R is an organic group reacting with an epoxy group and R¹ to R⁶ are silicon-containing groups having 0-3 repeat units of (SiRO_{3/2}); in case the unit of (SiRO_{3/2}) is zero, R¹ to R⁶ are independently H, CH₃ or C₂H₆), an epoxy resin and a photo initiator capable of initiating polymerization of the organic silicic compound or the epoxy resin upon absorption of actinic ray.

Semiconductor device comprises a semiconductor component having projected electrodes on the surface, a resin composition covering the projected electrodes and ball electrodes connected to the projected electrodes exposed from the resin composition, where the resin composition is a photo-curable resin composition, which comprises an organic silicic compound represented by the following general formula (1) or (2): 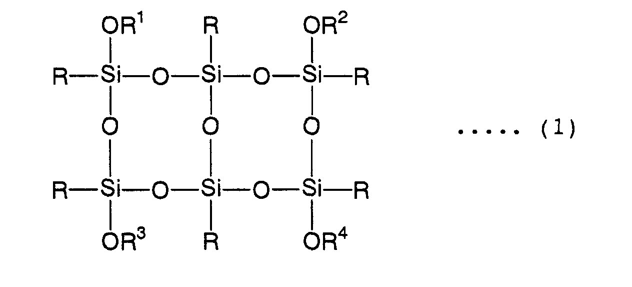 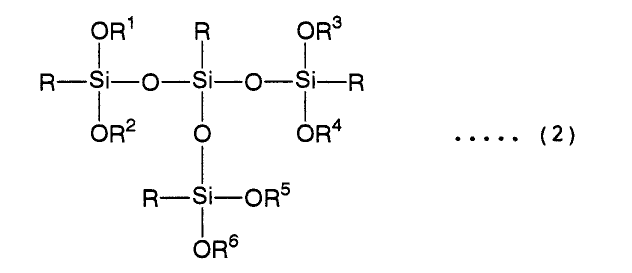 (where R is an organic group reacting with an epoxy group and R¹ to R⁶ are silicon-containing groups having 0-3 repeat units of (SiRO_{3/2}); in case the unit of (SiRO_{3/2}) is zero, R¹ to R⁶ are independently H, CH₃ or CH₂CH₃), an epoxy resin and a photo initiator capable of initiating polymerization of the organic silicic compound or the epoxy resin upon absorption of actinic ray.

The present invention will be described in detail below, referring to Examples and Comparative Examples, but the present invention is not limited thereto.

### Example 1

In Table 1, a photo-curable resin composition (in grams) according to Example 1 is shown, where 3-glycidoxytrimethoxysilane (S510, made by Chisso Corp.) was used as an organic silicic compound, tin dibutyldilaurate (DBDL T, made by Wako Pure Chemical Industries, Ltd.) as a hydrolysis catalyst, bisphenol A type epoxy resin (EP1001, made by Yuka Shell Co., Ltd.) as an epoxy resin, triallylsulfonium hexafluorophosphate type photo initiator (SP-70, made by Asahi Denka Kogyo K.K.), and resol resin (HP180R, made by Hitachi Chemical Co., Ltd.), imidazole (C11Z-Azine, made by Shikoku Chemical Corp.) and 1-acetoxy-2-methoxyethane (AC, made by Wako Pure Chemical Industries, Ltd.) as additives.

At first, 200 g of S510, 20 g of water and 2 g of DBLD T were added to a 300-ml beaker, stirred and left standing at room temperature for one day. 100 g of EP1001 was added to another 500-ml beaker, heated at 90°C over an oil bath with stirring for melting. Then, 177.6 g of the first liquid mixture consisting of S510, water and DBDL T was added to the second liquid mixture, followed by uniform mixing. Then, the resulting liquid mixture was heat treated at 150°C for 2 hours, and cooled down to 90°C. 150 g of AC was added thereto to dissolve the cooled liquid mixture. 100 g of HP180R, 3 g of C11Z-Azine and 2.5 g of SP-70 were added to and dissolved in the resulting solution.

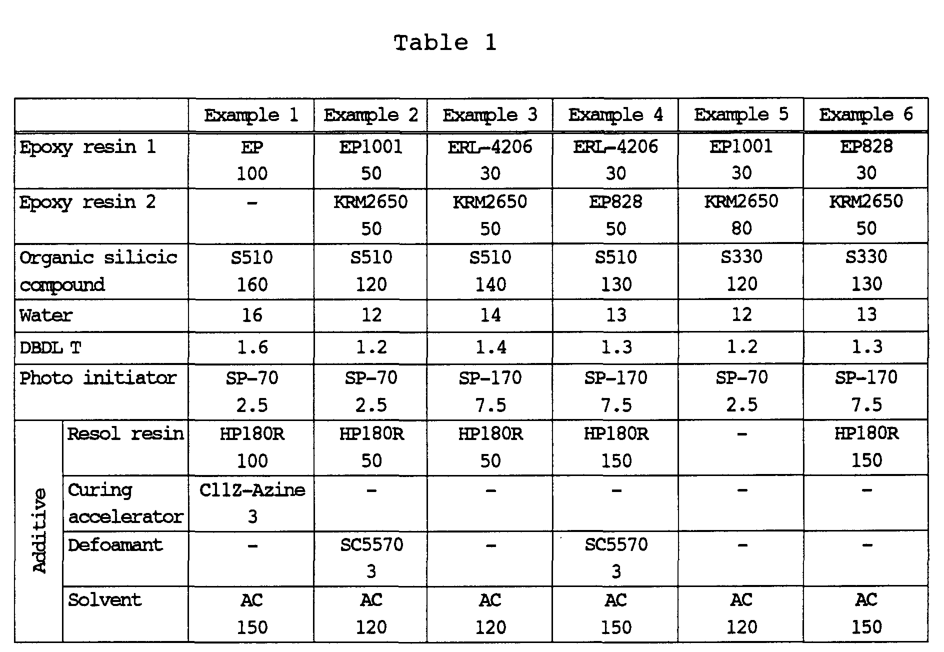

The composition thus prepared was applied to a copper foil by an applicator and heated at 80°C for 30 minutes for drying, thereby obtaining a 50 *µ*m-thick resin layer. After irradiation of ultraviolet ray at 1,500 mJ/cm² by a high pressure mercury lamp, the resin layer is heated at 150°C for 15 minutes and then at 140°C for 30 minutes for curing. Then, the copper foil was dissolved off to obtain a cured product. The resulting cured resin product was tested according to the following procedures to determine Tg, changes in modulus of elasticity by temperature and bonding strength to the copper foil.

### (1) Dynamic (storage) modulus of elasticity

The cured product thus obtained was cut into a test piece, 25 mm × 4 mm, and the test piece was tested to determine changes in dynamic (storage) modulus of elasticity by temperature by a rheospectrometer (model DVE4, made by Rheology Co., Ltd.) under the following conditions:
Temperature-elevating rate : 2°C/min.
Frequency : 10 Hz
Interchuck distance : 20 mm

In the test, a tan δ peak was presumed to be a glass transition temperature (Tg) and dynamic (storage) moduli of elasticity at room temperature (25°C) and a higher temperature by 40°C than Tg, respectively, were determined.

### (2) Coefficient of thermal expansion

The cured product thus obtained was cut into a test piece, 20 mm × 4 mm, and the test piece was tested to determine changes in the length of test piece by a TMA tester (made by Shinku Rikou Co., Ltd.) under the following conditions:
Temperature-elevating rate : 2°C/min.
Interchuck distance : 15 mm

Coefficient of thermal expansion was determined from changes in the length of test piece between room temperature (25°C) and a higher temperature by 40°C than Tg.

### (3) Bonding strength to copper foil

The photo-curable resin composition was applied to the mat surface of a 18 *µ*m-thick copper foil and dried to make the dried 75 *µ*m-thick resin layer. The resin-lined copper foil was then pressure bonded to a 5 mm-thick glass substrate by a laminator and then subjected to irradiation of ultraviolet ray from the glass substrate side in the same manner as in case of preparing the cured product and then to the similar heat treatments for curing. The copper foil was etched into 10 mm-wide test pieces, and the test pieces were peeled off at an angle of 90° at room temperature and a higher temperature by 40°C than Tg, respectively, to determine the bonding strength of the cured product to the copper foil test pieces. The bonding strength was presumed to be a peel strength.

### (4) Determination of resolution

Copper foil surfaces of a laminate board lined with 18 *µ* m-thick copper foils on both sides (MCL-67 Nw, made by Hitachi Chemical Co., Ltd.) were treated with a surface-roughening solution (containing 7 ml/ℓ of sulfuric acid and 180 g/ℓ of ammonium persulfate) at 30°C for 2 minutes to make finely uneven surfaces. The composition prepared according to Example 1 was applied to the copper foils by an applicator, heated at 80°C for 30 minutes and dried to obtain 50 *µ*m-thick resin layers, the resin layers were irradiated with ultraviolet ray from a high pressure mercury lamp in the same manner as above through a mask printed with circular holes having hole diameters of 10-250 *µ* m, the hole diameters being different from one to another at every interhole distance of 10 *µ*m. As a developing solution, there was used an aqueous 0.8 wt.% borax solution comprising 100 ml of 2-butoxyethanol, 100 ml of pure water, and 100 ml of an aqueous 15% tetramethylammonium hydroxide solution (the developing solution will be hereinafter referred to as "quasi-aqueous developing solution"). The irradiated resin layers were developed by spraying with the quasi-aqueous developing solution at 30°C for 1.5 minutes, then washed with water for 3 minutes and dried by injection of dry air. After the drying, holes thus formed were observed by an optical microscope or SEM, and the smallest diameter among the diameters of via holes formed by development was presumed to be "resolution".

### (5) ²⁹Si-NMR measurement

Pulverized cured product was subjected to ²⁹Si-NMR measurement by FT-NMR (model JNM-GSZ400, made by JEOL Ltd.) to determine chemical shift peak position and its integration value. A ratio of peak integration value at -53 ppm to -75 ppm to that at -40 ppm to -52 ppm was obtained. These characteristics are shown in Table 2.

**Table 2**

| | | Example 1 | Example 2 | Example 3 | Example 4 | Example 5 | Example 6 |
|---|---|---|---|---|---|---|---|
| Dynamic viscoelasticity | Tg (°C) | 180 | 185 | 180 | 185 | 160 | 175 |
| | Storage modulus of elasticity (25°C) (GPa) | 2.0 | 1.9 | 2.2 | 1.9 | 1.8 | 1.8 |
| | Storage modulus of elasticity (Tg+40°C) (GPa) | 0.45 | 0.4 | 0.5 | 0.55 | 0.4 | 0.4 |
| Bonding strength (kN/m) | Room temp. | 1.5 | 1.5 | 1.3 | 1.3 | 1.4 | 1.4 |
| | Tg+40°C | 0.8 | 0.9 | 0.8 | 0.7 | 0.8 | 0.8 |
| Resolution (*µ*m) | | 40 | 50 | 50 | 30 | 50 | 50 |
| Si-NMR results | | 6.9 | 5.2 | 6.8 | 7.5 | 5.2 | 8.5 |

### Example 2

Photo-curable resin composition (in grams) according to Example 2 is shown in Table 1, where 3-glycidoxytrimethoxysilane (S510, made by Chisso Corp.) was used as an organic silicic compound, tin dibutyldilaurate (DBDL T, made by Wako Pure Chemical Industries, Ltd.) as a hydrolysis catalyst, bisphenol A type epoxy resin (EP1001, made by Yuka Shell Co., Ltd.) and o-cresol novolak type epoxy resin (KRM2650, made by Asahi Denka Kogyo K.K.) as epoxy resins, triallylsulfonium hexafluorophosphate type photo initiator (SP-70, made by Asahi Denka Kogyo K.K.), and resol resin (HP180R, made by Hitachi Chemical Co., Ltd.) a defoamant (SC5570, made by Toray Silicone Co., Ltd.) and 1-acetoxy-2-methoxyethane (AC, made by Wako Pure Chemical Industries, Ltd.) as additives.

At first, 200 g of S510, 20 g of water and 2 g of DBDL T were added to a 300-ml beaker, stirred and left standing at room temperature for one day. 50 g of EP1001 and 50 g of KRM2650 were added to another 500-ml beaker, heated over an oil bath at 90°C with stirring for melting. 133.2 g of the first liquid mixture consisting of S510, water and DBDL T was added to the second liquid mixture, followed by uniform mixing. Then, the resulting liquid mixture was heat treated at 150°C for one hour and cooled down to 90°C. 120 g of AC was added thereto to dissolve the cooled liquid mixture. 50 g of HP180R, 3 g of SC5570 and 2.5 g of SP-70 were added to and dissolved in the resulting solution.

In this Example, preparation of cured product and evaluation of characteristics were carried out in the same manner, and the results are shown in Table 2.

### Example 3

Photo-curable resin composition (in grams) according to Example 3 is shown in Table 1, where 3-glycidoxytrimethoxysilane (S510, made by Chisso Corp.) was used as an organic silicic compound, tin dibutyldilaurate (DBDL T, made by Wako Pure Chemical Industries, Ltd.) as a hydrolysis catalyst, alicyclic epoxy resin (ERL-4206, made by Union Carbide Corp.) and o-cresol novolak epoxy resin (KRM2650, made by Asahi Denko K.K.) as epoxy resins, triallylsulfonium hexafluorophosphate type photo initiator (SP-170, made by Asahi Denka Kogyo K.K.), and resol resin (HP180R, made by Hitachi Chemical Co., Ltd.) and 1-acetoxy-2-methoxyethane (AC, made by Wako Pure Chemical Industries, Ltd.) as additives.

At first, 200 g of S510, 20 g of water and 2 g of DBDL T were added to a 300-ml beaker, stirred and left standing at room temperature for one day. 30 g of ERL-4206 and 50 g of KRM2650 were added to another 500-ml beaker, heated over an oil bath at 90°C with stirring for melting. 155.4 g of the first liquid mixture consisting of S510, water and DBDL T was added to the second liquid mixture, followed by uniform mixing. Then, the resulting liquid mixture was heat treated at 150°C for one hour, and cooled down to 90°C. 120 g of AC was added thereto to dissolve the cooled liquid mixture. 50 g of HP180R and 7.5 g of SP-170 were added to and dissolved in the resulting solution.

In this Example, preparation of cured product and evaluation of characteristics were also carried out in the same manner as in Example 1, and the results are shown in Table 2.

### Example 4

Photo-curable resin composition (in grams) according to Example 4 is shown in Table 1, where 3-glycidoxytrimethoxysilane (S510, made by Chisso Corp.) was used as an organic silicic compound, tin dibutyldilaurate (DBDL T, made by Wako Pure Chemical Industries, Ltd.) as a hydrolysis catalyst, alicyclic epoxy resin (ERL-4206, made by Union Carbide Corp.) and bisphenol A type epoxy resin (EP828, made by Yuka Shell Co., Ltd.) as epoxy resins, and triallylsulfonium hexafluorophosphate type photo initiator (SP170, made by Asahi Denka K.K.), and furthermore, resol resin (HP180R, made by Hitachi Chemical Co., Ltd.) a defoamant (SC5570, made by Toray Silicone Co., Ltd.) and 1-acetoxy-2-methoxyethane (AC, made by Wako Pure Chemical Industries, Ltd.) were used as additives.

At first, 200 g of S510, 20 g of water and 2 g of DBDL T were added to a 300-ml beaker, stirred and left standing at room temperature for one day. 30 g of ERL-4206 and 50 g of EP828 were added to another 500-ml beaker and heated over an oil bath at 90°C with stirring for melting. 144.3 g of the first liquid mixture consisting of S510, water and DBDL T was added to the second liquid mixture, followed by uniform mixing. Then, the resulting liquid mixture was heat treated at 150°C for one hour and cooled down to 90°C. 120 g of AC was added thereto to dissolve the cooled liquid mixture. Then, 150 g of HP180R, 3 g of SC5570 and 7.5 g of SP-170 were added to and dissolved in the resulting solution.

In this Example, preparation of cured product and evaluation of characteristics were also carried out in the same manner as in Example 1, and the results are shown in Table 2.

### Example 5

Photo-curable resin composition (in grams) according to Example 5 is shown in Table 1, where 3-aminopropyltriethoxysilane (S330, made by Chisso Corp.) was used as an organic silicic compound, tin dibutyldilaurate (DBDL T, made by Wako Pure Chemical Industries, Ltd.) as a hydrolysis catalyst, bisphenol A type epoxy resin (EP1001, made by Yuka Shell Co., Ltd.) and o-cresol novolak type epoxy resin (KRM2650, made by Asahi Denka Kogyo K.K.) as curable epoxy resins, triallylsulfonium hexafluorophosphate (SP-70, made by Asahi Denka Kogyo K.K.) as a photo initiator, and 1-acetoxy-2-methoxyethane (AC, made by Wako Pure Chemical Industries, Ltd.) as an additive.

At first, 200 g of S330, 20 g of water and 2 g of DBDL T were added to a 300-ml beaker, stirred and left standing at room temperature for one day. 30 g of EP1001 and 80 g of KRM2650 were added to another 500-ml beaker and heated over an oil bath at 90°C with stirring for melting, and 133.2 g of the first liquid mixture consisting of S330, water and DBDL T was added to the second liquid mixture, followed by uniform mixing. Then, the resulting liquid mixture was heat treated at 150°C for one hour and cooled down to 90°C. Then, 120 g of AC was added thereto to dissolved the cooled liquid mixture. Then, 50 g of HP180R and 2.5 g of SP-70 were added to and dissolved in the resulting solution. Preparation of cured product and evaluation of characteristics were also carried out in the same manner as in Example 1 and the results are shown in Table 2.

### Example 6

Photo-curable resin composition (in grams) according to Example 6 is shown in Table 1, where 3-aminopropyltriethoxysilane (S330, made by Chisso Corp.) was used as an organic silicic compound, tin dibutyldilaurate (DBDL T, made by Wako Pure Chemical Industries, Ltd.) as a hydrolysis catalyst, alicyclic epoxy resin (ERL-4206, made by Union Carbide Corp.) and bisphenol A type epoxy resin (EP828, made by Yuka Shell Co., Ltd.) as epoxy resins, and triallylsulfonium hexafluorophosphate type photo initiator (SP-170, made by Asahi Denka Kogyo K.K.). Furthermore, resol resin (HP180R, made by Hitachi Chemical Co., Ltd.) and 1-acetoxy-2-methoxyethane (AC, made by Wako Pure Chemical Industries, Ltd.) were used as additives.

At first, 200 g of S330, 20 g of water and 2 g of DBDL T were added to a 300-ml beaker, stirred and left standing at room temperature for one day. 30 g of ERL-4206 and 50 g of EP828 were added to another 500-ml beaker and heated over an oil bath at 90°C with stirring for melting. 144.3 g of the first liquid mixture consisting of S330, water and DBDL T was added to the second liquid mixture, followed by uniform mixing. Then, the resulting mixture was heat treated at 150°C for one hour and cooled down to 90°C. Then, 120 g of AC was added thereto to dissolve the resulting cooled mixture. 150 g of HP180R and 7.5 g of SP-170 were added to and dissolved in the resulting solution. Preparation of cured product and evaluation of characteristics were carried out in the same manner as in Example 1, and the results are shown in Table 2.

In these Examples, decreases in the storage modulus of elasticity and the bonding strength from room temperature to 220°C, which is higher than the glass transition temperatures, can be controlled within about 1/5. Resolution is in a range of 60-30 *µ*m, which can be evaluated as a high resolution. Results of ²⁹Si-NMR measurement of these cured products and determination of their chemical shift peak positions and integration values reveal that ratios of peak integration values at -53 ppm to -75 ppm to those at -40 ppm to -52 ppm are all 6 or more, showing formation of silane compounds of oligomer level sizes in the present invention.

### Comparative Example 1

Photo-curable resin composition (in grams) according to Comparative Example 1 is shown in Table 3, where bisphenol A type epoxy resin (EP1001, made by Yuka Shell Co., Ltd.) was used as curable resin, triallylsulfonium hexafluorophosphate type photo initiator (SP-70, made by Asahi Denka Kogyo K.K.), and resol resin (HP180R, made by Hitachi Chemical Co., Ltd.) and 1-acetoxy-2-methoxyethane (AC, made by Wako Pure Chemical Industries, Ltd.) as additives.

**Table 3**

| | | Comp. Ex. 1 | Comp. Ex. 2 | Comp. Ex. 3 | Comp. Ex. 4 | Comp. Ex. 5 |
|---|---|---|---|---|---|---|
| Curable resin | Epoxy resin 1 | EP1001 100 | EP1001 100 | EP1001 50 | EP1001 50 | EP1001 50 |
| | Epoxy resin 2 | - | - | KRM2650 50 | KRM2650 50 | KRM2650 50 |
| Organic silicic compound | | - | - | - | - | S510 120 |
| Water | | - | - | - | - | 12 |
| DBDL T | | - | - | - | - | 1.2 |
| Photo initiator | | SP-70 2.5 | SP-70 2.5 | SP-70 2.5 | SP-70 2.5 | SP-70 2.5 |
| Additive | Resol resin | HP180R 100 | HP180R 100 | HP180R 50 | HP180R 50 | HP180R 50 |
| | Silica filler | - | Crystalite 5X 30 | - | Crystalite 5X 21 | - |
| | Solvent | AC 85 | AC 60 | AC 70 | AC 50 | AC 20 |

At first, 100 g of EP1001 and 100 g of HP180R were added to a 300-ml, three-necked flask and heated over an oil bath at 90°C with stirring for melting. 85 g of AC was added thereto to dissolve the epoxy resin 2.5 g of SP-70 was added to and dissolved in the resulting solution. Preparation of cured product was carried out in the same manner as in Example 1. Evaluation of physical properties and resolution of cured product was carried out in the same manner as in Example 1. The results are shown in Table 4.

**Table 4**

| | | Comp. Ex. 1 | Comp. Ex. 2 | Comp. Ex. 3 | Comp. Ex. 4 | Comp. Ex. 5 |
|---|---|---|---|---|---|---|
| Dynamic viscoelasticity | Tg (°C) | 180 | 180 | 190 | 188 | 155 |
| | Storage modulus of elasticity (25°C) (GPa) | 2.9 | 3.2 | 3.4 | 3.2 | 3.4 |
| | Storage modulus of elasticity (Tg+40°C) (GPa) | 0.036 | 0.15 | 0.063 | 0.15 | 0.063 |
| Bonding strength (kN/m) | Room temp. | 1.4 | 1.5 | 1.2 | 1.3 | 1.3 |
| | Tg+40°C | 0.2 | 0.2 | 0.15 | 0.15 | 0.1 |
| Resolution (*µ*m) | | 50 | 100 | 50 | 110 | 50 |

### Comparative Example 2

Photo-curable resin composition (in grams) according to Comparative Example 2 is shown in Table 3, where bisphenol A type epoxy resin (EP1001, made by Yuka Shell Co., Ltd.) was used as a curable resin, triallylsulfonium hexafluorophosphate type photo initiator (SP-70, made by Asahi Denka Kogyo K.K.), and resol resin (HP180R, made by Hitachi Chemical Co., Ltd.), 1-acetoxy-2-methoxyethan (AC, made by Wako Pure Chemical Industries, Ltd.) and a silica filler having an average particle size of 1 *µ*m (Crystalite 5Z, made by Tatsumori K.K.) as additives.

At first, 100 g of EP1001 and 100 g of HP180R were added to a 300-ml, three-necked flask and heated over an oil bath at 90°C with stirring for melting. 60 g of AC was added thereto to dissolve the epoxy resin. 2.5 g of SP-70 was added to and dissolved in the resulting solution, followed by addition of 30 g of Crystalite 5Z thereto and uniform kneading through three rolls. Preparation of cured product and evaluation of characteristics were carried out in the same manner as in Comparative Example 1, and the results are shown in Table 4.

### Comparative Example 3

Photo-curable resin composition (in grams) according to Comparative Example 3 is shown in Table 3, where bisphenol A type epoxy resin (EP1001, made by Yuka Shell Co., Ltd.) and o-cresol novolak type epoxy resin (KRM2650, made by Asahi Denka Kogyo K.K.) were used as curable resins, triallylsulfonium hexafluorophosphate type photo initiator (SP-70, made by Asahi Denka Kogyo K.K.), and resol resin (HP180R, made by Hitachi Chemical Co., Ltd.) and 1-acetoxy-2-methoxy-ethane (AC, made by Wako Pure Chemical Industries, Ltd.) as additives.

At first, 50 g of RP1001 and 50 g of KRM2650 were added to a 300-ml, three-necked flask and heated over an oil bath at 90°C with stirring for melting. 70 g of AC was added thereto to dissolve the mixture and 2.5 g of SP-70 was added to and dissolved in the resulting solution. Preparation of cured product and evaluation of characteristics were carried out in the same manner as in Comparative Example 1. The results are shown in Table 4.

### Comparative Example 4

Photo-curable resin composition (in grams) according to Comparative Example 4 is shown in Table 3, where the resin composition was prepared in the same manner as in Comparative Example 3, except that 21 g of Crystalite 5Z was used, and the resin composition was kneaded through three rolls to uniformly disperse Crystalite 5Z, thereby obtaining a final photo-curable resin composition. Preparation of cured product and evaluation of characteristics were carried out in the same manner as in Comparative Example 1. The results are shown in Table 4.

### Comparative Example 5

Photo-curable resin composition (in grams) according to Comparative Example 5 is shown in Table 3, where 3-glycidoxytrimethoxysilane (S510, made by Chisso Corp.) was used as an organic silicic compound, Tin dibutyldilaurate (DBDL T, made by Wako Pure Chemical Industries, Ltd.) as a hydrolysis catalyst, bisphenol A type epoxy resin (EP1001, made by Yuka Shell Co., Ltd.) and o-cresol novolak type epoxy resin (KRM2650, made by Asahi Denka Kogyo K.K.) as curable resins, triallylsulfonium hexafluorophosphate type photo initiator (SP-70, made by Asahi Denka Kogyo K.K.), and resol resin (HP180R, made by Hitachi Chemical Co., Ltd.) and 1-acetoxy-2-methoxyethane (AC, made by Wako Pure Chemical Industries, Ltd.) as additives.

At first, 50 g of EP1001 and 50 g of KRM2650 were added to a 500-ml, three-necked flask and heated over an oil bath at 90°C with stirring for melting. Then, 20 g of AC was added thereto to dissolve the resulting liquid mixture. Furthermore, 120 g of S510, 12 g of water and 1.2 g of DBDL T were added thereto, followed by uniform mixing. The resulting liquid mixture was cooled down to room temperature, and then 2.5 g of SP-70 was added and dissolved in the resulting solution. Preparation of cured product and evaluation of characteristics were carried out in the same manner as in Comparative Example 1. The results are shown in Table 4.

²⁹Si-NMR measurement of the cured products of photo-curable resin compositions according to the foregoing Comparative Examples was carried out to determine their chemical shift peak positions and their integration values. It was found that ratios of peak integration values at -53 ppm to -75 ppm to those at -40 ppm to -52 ppm were all approximately 0.6, showing no formation of silane compounds of oligomer level size as in the present invention.

Characteristics of cured products of Examples 1 to 6 are shown in Table 2, where decreases in the storage modulus of elasticity and the bonding strength from room temperature to 220°C, which is higher than the glass transition temperatures, can be controlled within about 1/5, and also resolution is in a range of 60-30 *µ*m, which can be evaluated as a high resolution.

Characteristics of cured products of Comparative Examples will be explained below in contrast to those of Examples.

Comparative Example 1 corresponds to Example 1, except that no organic silicic compound of Example 1 is used, and shows large differences in the storage modulus of elasticity between room temperature higher temperature than Tg and considerable changes in the physical properties at higher temperatures than Tg. Actually, the bonding strength at higher temperatures becomes very low, as compared with that at room temperature, and when applied to different kinds of materials as an adhesive, peeling of the adhesive will often take place due to developed thermal stresses. Furhermore, due to low storage modulus of elasticity at higher temperatures than Tg the cured product will easily undergo deformation by an external force, when applied at higher temperatures than Tg.

On the other hand, Comparative Example 2 shows the same resin composition as that of Example 1, except that a silica filler is used in place of the organic silicic compound of Example 1. Comparative Example 2 contains substantially the same O-Si-O skeleton component as in Example 1 in the form of a filler, and thus the storage modulus of elasticity at higher temperatures than Tg is improved, but the bonding strength at higher temperatures is not improved and resolution is lowered due to light scattering by the filler.

Comparative Example 3 corresponds to Example 2, except that no organic silicic compound is used, and shows large differences in the storage modulus of elasticity between room temperature and higher temperatures than Tg and considerable changes in the physical properties at higher temperatures than Tg, as in Comparative Example 1.

Comparative Example 4 shows the same resin composition as that of Example 2, except that a silica filler is used in place of the organic silicic compound of Example 2. No improvement of the bonding strength is observed and lowering of resolution is observed, as in Comparative Example 2.

Comparative Example 5 uses an organic silicic compound, but the curable resin composition of Comparative Example 5 is prepared without heat treatment of the organic silicic compound in the curable resin in contrast to the present invention. NMR measurement results show that polymerization of the organic silicic compound fails to proceed. That is, in spite of the fact that the same amount of the organic silicic compound as in Example 2 is used as a starting material, it has been found that changes in the storage modulus of elasticity between room temperature and higher temperatures than Tg are the same as in Comparative Example 3 using no organic silicic compound, and the physical properties are considerably changed between room temperature and higher temperatures than Tg.

As shown above, in Examples 1 to 6, the cured products show at 200° to 225°C the storage modulus of elasticity of 0.4 to 0.55 GPa and the bonding strength of 0.7 to 0.9 kN/m, respectively. These values have differences of -1.25 to -1.89 GPa and -0.4 to -0.8 kN/m, respectively, compared with the values at room temperature (25°C). Comparing with the same differences in the values in Comparative Examples 1 to 5, that is, -2.8 to -3.3 GPa in the storage modulus of elasticity and -1.0 to -1.4 kN/m in the bonding strength, the above-mentioned values in the present invention are clearly smaller in the absolute value. As a result, it can be said that the storage modulus of elasticity and the bonding strength of cured products according to the present invention are maintained at high temperatures higher than Tg.

A photo-curable resin composition effective for photo-curable insulating layers on electronic parts including build-up type multilayered wiring boards, capable of producing cured products with less light scattering, distinguished resolution, and small decrease in physical properties at higher temperatures than the glass transition temperature, can be obtained according to the present invention.

The present inventors have made further studies on the process for producing the present photo-curable resin composition as follows:

### Example 7

Conditions for heat treatment of photo-curable resin composition according to Example 7 are shown in Table 5.

Resin composition was prepared in the same manner as in Example 2, except that heat treatment was carried out under changed conditions after addition of a liquid mixture of S510, water and DBDL T to EP1001 and KRM2650, followed by uniform mixing. Temperature and time used for the heat treatment were 60°C for one hour and 60°C for 10 hours; 80°C for 4 hours; 160°C for one hour; and 160°C for 4 hours. Preparation of cured products and evaluation of characteristics were carried out in the same manner as in Example 1. The results are shown in Table 5.

**Table 5**

| | | Comp. Ex. 6 | Comp. Ex. 7 | Comp. Ex. 8 | Example 7 | | | | |
|---|---|---|---|---|---|---|---|---|---|
| Heat treatment conditions | | 50°C-1 hr. | 50°C-10 hr. | 150°C-0.5 hr. | 60°C-1 hr. | 60°C-10 hr. | 80°C-4 hr. | 160°C-1 hr. | 160°C-4 hr. |
| Dynamic visco-elasticity | Tg (°C) | 110 | 120 | 155 | 155 | 165 | 165 | 160 | 150 |
| | Storage modulus of elasticity (25°C) (GPa) | 2.2 | 2.0 | 1.9 | 1.9 | 1.9 | 1.9 | 1.9 | 1.8 |
| | Storage modulus of elasticity (Tg+40°C) (GPa) | 0.025 | 0.036 | 0.036 | 0.3 | 0.3 | 0.2 | 0.4 | 0.4 |
| Bonding strenqth strength (kN/m) | Room temp. | 1.5 | 1.5 | 1.5 | 1.5 | 1.5 | 1.5 | 1.5 | 1.4 |
| | Tg+40°C | 0.1 | 0.1 | 0.15 | 0.5 | 0.9 | 0.9 | 0.9 | 0.8 |
| Resolution (*µ*m) | | 40 | 40 | 40 | 50 | 50 | 50 | 50 | 60 |
| Si-NKR results | | 0.1 | 0.1 | 0.1 | 2.5 | 3.0 | 7.5 | 13 | 15 |

### Comparative Examples 6 - 9

Conditions for heat treatment of photo-curable resin compositions according to Comparative Examples 6 - 9 are shown in Table 5.

Resin compositions were prepared in the same manner as in Example 2, except that heat treatment was carried out unde changed conditions after addition of a liquid mixture of S510, water and DBDL T to EP1001 and KRM2650, followed by uniform mixing. Temperature and time used for the heat treatment were 50°C for one hour (Comparative Example 6), 50°C for 10 hours (Comparative Example 7), 150°C for 0.5 hours (Comparative Example 8) and 170°C for one hour (Comparative Example 9), but in case of 170°C for one hour of Comparative Example 9, the liquid mixture underwent gelling, resulting in failure to evaluate the characteristics. Preparation of cured products and evaluation of characteristics were carried out in the same manner as in Example 1. The results are shown in Table 5.

In case of cured products obtained according to Example 7, decreases in the storage modulus of elasticity and the bonding strength from room temperature to higher temperatures than Tg can be controlled within 1/10 by conducting heat treatment at 60°C for one hour, 60°C for 10 hours, 80°C for 4 hours, 160°C for one hour or 160°C for 4 hours, showing that the cured products have a high stability at higher temperatures. Furthermore, it has been found that the organic silicic compound in the cured product underwent oligomer level polymerization. On the other hand, in Comparative Examples 6, 7 and 8 using mild heating conditions, condensation of organic silicic compound failed to proceed, resulting in no improvement of mechanical characteristics. In Comparative Example 9 using severe heating conditions, liquid mixture underwent gelling, resulting in failure to prepare test pieces.

A multilayered wiring board with blind via holes was prepared in the following manner, using the afore-mentioned photo-curable resin composition and its characteristics as a semiconductor package were evaluated.

### Example 8

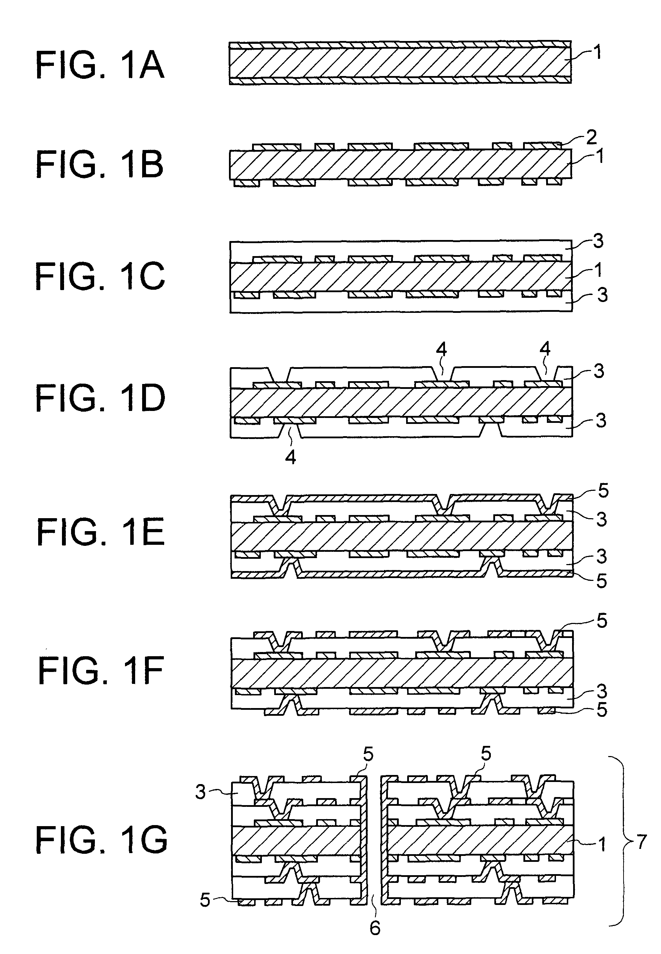

Figs. 1A-1G are schematic view showing a flow of process steps of preparing a six-layered wiring board.

Laminate board 1 lined with 18 *µ*m-thick copper foils of ultraviolet ray-nontransmissible type on both sides (NCL-67Nw, made by Hitachi Chemical Co., Ltd.) was used and inner layer power source circuit 2 was formed thereon by predetermined etching. Copper foil surface of the circuit was treated with a roughening solution containing 7 ml/ℓ of sulfuric acid and 180 g/ℓ of ammonium persulfate at 30°C for 2 minutes to make a finely uneven surface. After water washing, the finely uneven surface was treated with an oxide film-forming solution containing 35 g/ℓ of trisodium phosphate, 100 g/ℓ of sodium perchlorate and 10 g/ℓ of sodium hydroxide at 70°C for 5 minutes to form an oxide film in an ultramicrogranular state on the finely uneven surface. After water washing, the oxide film was treated with a reducing solution containing 10 g/ℓ of dimethylamineborane and 7 g/ℓ of sodium hydrode at 40°C for 2 minutes to reduce the oxide film. After water washing, water was removed by nitrogen gas injection to dry the surface.

Photo-curable resin composition 3 of Example 2 was applied to one side of the inner layer circuit board by screen printing, heated at 60°C for 20 minutes and dried. The resin composition was also applied to the other side in the same manner as above, heated at 60°C for 30 minutes and dried, where the resin layers were each made to have a thickness of 50 *µ*m. Both layers were then irradiated with parallel ultraviolet ray of a high pressure mercury lamp at 1,500 mJ/cm² through masks printed with via holes, 50 *µ*m in diameter, at predetermined positions, and then developed with an aqueous 1 wt.% sodium carbonate solution at 30°C for 150 seconds by spraying, followed by further irradiation at 1 J/cm² and heating at 150°C for one hour.

Photo-curable resin composition surface 3 on the board was roughened with a chemical roughening solution containing 80 g/ℓ of potassium permanganate, whose pH was adjusted to 13 by potassium hydroxide, at 50°C for 5 minutes and washed with water, followed by hot water washing at 50°C for 5 minutes. Then, the roughening residue was removed with an aqueous 6 g/ℓ sodium hydroxide solution. The surface was further washed with water, and then the board was dipped into a catalyst solution containing palladium acting as a catalyst for electroless plating (chemical plating) reaction (HS101B, made by Hitachi Chemical Co., Ltd.) and again washed with water, followed by activation of the catalyst with an aqueous 100 ml/ℓ hydrochloric acid solution. Then, the board was dipped into an electroless copper plating solution containing 10 g/ℓ of copper sulfate, 30 g/ℓ of ethylenediaminetetraacetic acid, 3 ml/ℓ of an aqueous 37% HCHO solution and 30 mg/ℓ of *α*,*α*'-dipyridyl, whose pH was adjusted to 12.5 by sodium hydroxide, at 70°C for 10 minutes to form copper plating films 5, about 30 *µ*m thick, thick, in blind via holes 4 and wiring board surfaces. The copper plating films were washed with water and then heat treated at 160°C for 30 minutes.

Etching resist was provided on the copper plating, and then the copper was etched to form a circuit. The foregoing procedures were successively repeated to form two inner layer circuits on each side and finally throughholes 6 and an outemost circuit layer were formed. It was confirmed that through the foregoing process steps, a multilayered wiring board, 27 mm × 27 mm, was finally prepared without any problems. In Fig. 1G, numeral 7 shows a build-up type multilayered wiring board.

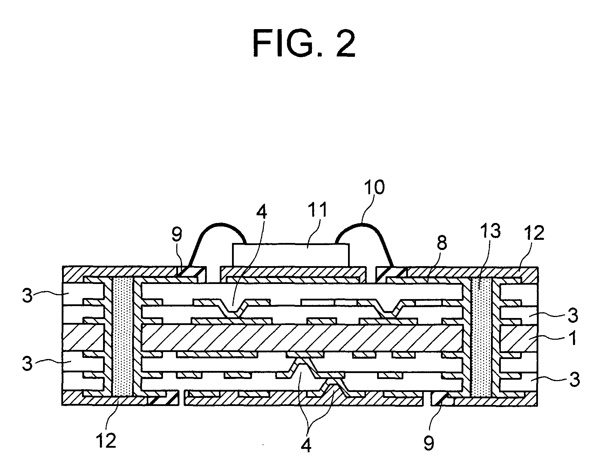

Filler resin 13 (CCT-65TH, made by Asahi Research Laboratory Co., Ltd.) was filled into the throughholes of the wiring board by screen printing and cured at 170°C for one hour. Then, as shown in Fig. 2, solder resist 12 and gold plating 9 were provided at desired positions, where insulating layers 3 were 45 *µ*m thick. Die bonding paste (EN-4000, made by Hitachi Chemical Co., Ltd.) was potted in an area, 7 mm × 7 mm, by a dispenser, and semiconductor chip 11, 7 mm × 7 mm, was provisionally bonded thereto at 180° for one minute under a load of 5 kg/cm². Then, the paste was cured at 180°C for one hour. In Fig. 2, numeral 8 shows copper wirings.

Then, wire bonding was carried out between the bonding parts and semiconductor chip 11 on the printed wiring board, using gold wire 10, 30 *µ*m in diameter, by a manual bonding apparatus. Bonding conditions were as follows:
Ultrasonic wave frequency : 60 kHz
Ultrasonic wave output power : 100 mW
Load : 100 g
Bonding time : 30 ms
Bonding temperature : 220°C

To investigate the thickness of the insulating layer under the bonding parts, the cross-sections of cutout test pieces were inspected. It was found that the thickness of the insulating layer just under the bonding parts was changed by 0.5 *µ*m, showing no electrical insulation problem.

50 pieces of the foregoing packages were subjected to a temperature cycle test. One temperature cycle consisting of -50°C kept for 10 minutes and 150°C kept for 10 minutes was repeated and conductivity of electric signal was investigated at every 50 cycles. Evaluation was made on the basis of number of cycles at a 50% cummulative failure occurrence rate. In this Example, it was confirmed that the electric signals were conducted without any troubles even at 3,000 cycles or more.

### Example 9

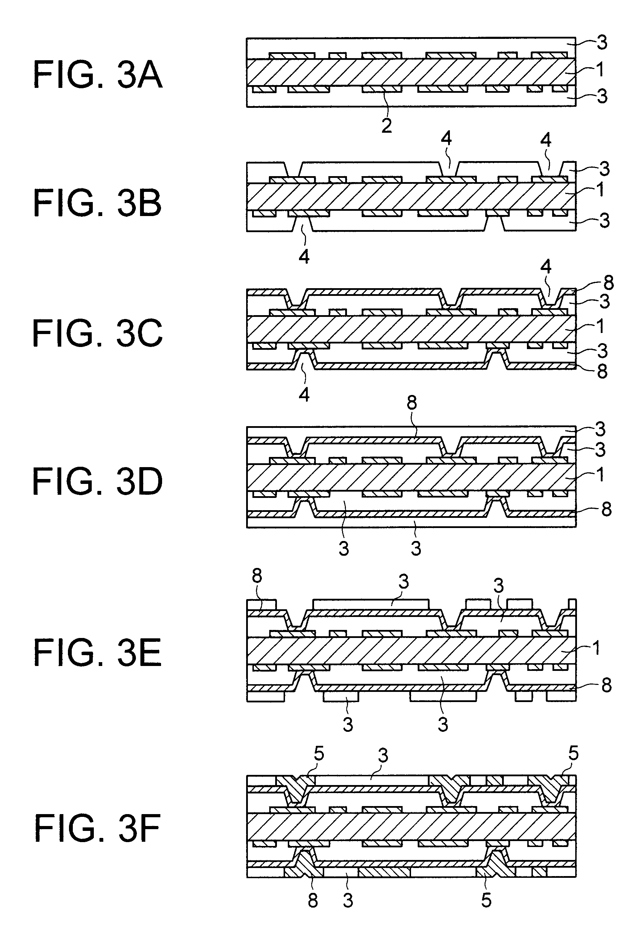

Figs. 3A-3F are schematic views showing a flow of process steps of preparing a five-layered wiring board, and Fig, 4 is a cross-sectional view of the five-layered wiring board thus prepared.

Laminate plate 1 lined with 18 *µ*m-thick copper foils of ultraviolet ray nontransmissible type on both sides (NCL-67Nw, made by Hitachi Chemical Co., Ltd.) was used, and inner layer power source circuit 2 was formed thereon by predetermined etching. Copper foil surface of the circuit was treated with a roughening solution containing 7 ml/ℓ of sulfuric acid and 180 g/ℓ of ammonium sulfate at 30°C for 2 minutes to make a finely uneven surface. After water washing; the finely uneven surface was treated with an oxide film-forming solution containing 35 g/ℓ of trisodium phosphate, 100 g/ℓ of sodium perchlorate and 10 g/ℓ of sodium hydroxide at 70°C for 5 minutes to form an oxide film in an ultramicrogranular state on the finely uneven surface. After water washing, the oxide film was treated with a reducing solution containing 10 g/ℓ of dimethylamineborane and 7 g/ℓ of sodium hydroxide at 40°C for 2 minutes to reduce the oxide film. After water washing, water was removed by nitrogen gas injection to dry the surface.

Both sides of the inner layer circuit board was dipped into a catalyst solution containing palladium acting as catalyst 8 for electroless plating (chemical plating) (HS101B, made by Hitachi Chemical Co., Ltd.) for 2 minutes and dried. Then, photo-curable resin composition 3 of Example 2 was applied to one side of the circuit board by screen printing, heated at 60°C for 20 minutes, and dried. The resin composition was also applied to the other side in the same manner as above, heated at 60°C for 30 minutes and dried, where the resin layers were each made to have a thickness of 50 *µ*m. Both layers were then irradiated with parallel ultraviolet ray of a high pressure mercury lamp at 400 mJ/cm² through masks printed with via holes, 50 *µ* m in diameter, at predetermined positions, and then developed with an aqueous 1 wt.% sodium carbonate solution at 30°C for 150 seconds, followed by further irradiation at 1 J/cm² and heating at 150°C for one hour.

After water washing again, catalyst 8 was activated with an aqueous 100 ml/ℓ hydrochloric acid solution. The wiring board was dipped into an electroless copper plating solution containing 10 g/ℓ of copper sulfate, 30 g/ℓ of ethylenediaminetetraacetic acid, 3 ml/ℓ of an aqueous 37% HCHO solution and 30 mg/ℓ of *α*,*α*'-dipyridyl, whose pH was adjusted to 12.5 by sodium hydroxide, at 70°C for ten hours to form copper plating films, about 30 *µ*m thick, in blind via holes 4 and on the surfaces of the wiring board. The wiring board was washed with water and heat treated at 160°C for 30 minutes. The foregoing procedures were successively repeated to make a multilayered wiring board with 4 wiring layers on one side and 2 wiring layer on the other side, with 45 *µ*m-thick insulating layers 3. Finally, throughholes 6 and outermost circuit layer were formed to prepare a printed wiring board 7 as shown in Fig. 1G.

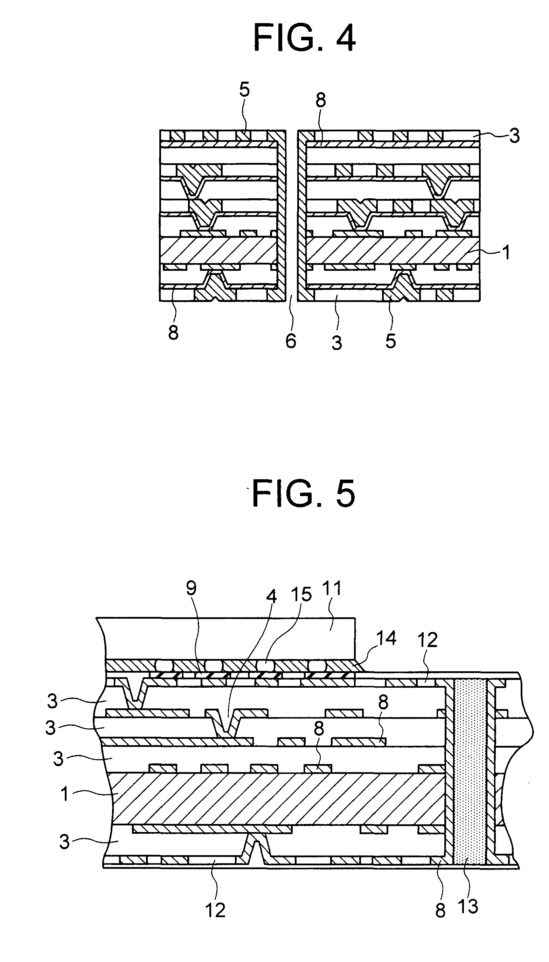

Fig. 5 is a cross-sectional view showing a multilayered printed wiring board, 27 mm × 27 mm, prepared according to the foregoing procedures. In Fig. 5, filler resin 13 was filled and cured in the same manner as in Example 8, and solder resists 12 and gold platings 9 were provided at predetermined positions. Semiconductor chip 11, 10 mm × 10 mm in outer configuration, on which solder balls 15 were formed at center-to-center distances of 160 *µ*m, was provided on the wiring board and bonded thereto by IR reflow after alignment. Underfill 14 (LPD197, made by Japan Locktight Co., Ltd.) was filled between the semiconductor chip and the wiring board and heat cured at 150°C for 12 hours. In spite of such a difference in the numbers of wiring layers between the upper side and the lower side of the wiring board, packaging could be made without any warping problems.

The foregoing package was subjected to a temperature cycle test in the same manner as in Example 8. No abnormality of electric signals was found at 3,000 cycles or more in this Example.

### Comparative Example 10

Preparation of a wiring board, mounting of semiconductor chips, and bonding with gold wires were carried out in the same manner as in Example 8, except that photo-curable resin of Comparative Example 4 was used. To investigate the thickness of the insulating layer under the bonding parts, cross-sections of cutout test pieces was inspected, and it was found that the thickness of the insulating layer just under the bonding parts was decreased by 22 *µ*m, showing an electric insulation problem.

The package was subjected to a temperature cycle test in the same manner as in Example 8 and abnormality of electric signals was found at 1,000 cycles in this Comparative Example.

### Comparative Example 11

Preparation of a wiring board and mounting of semiconductor chips were carried out in the same manner as in Example 9, except that photo-curable resin composition of Comparative Example 4 was used.

The resulting package was subjected to a temperature cycle test in the same manner as in Example 8. Abnormality of electric signals was found at about 500 cycles in this Comparative Example.

It is obvious from the foregoing results of reliability tests of wiring boards prepared in Examples 8 and 9 and Comparative Examples 10 and 11 and packages using the boards that the wiring boards using the present photo-curable resin compositions are more reliable than those of Comparative Examples.

### Example 10

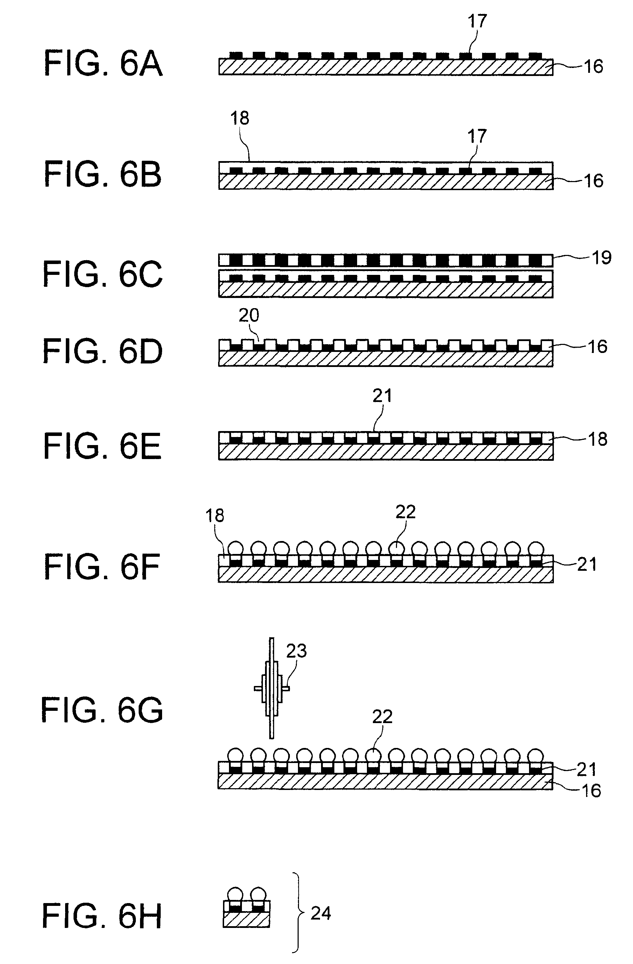

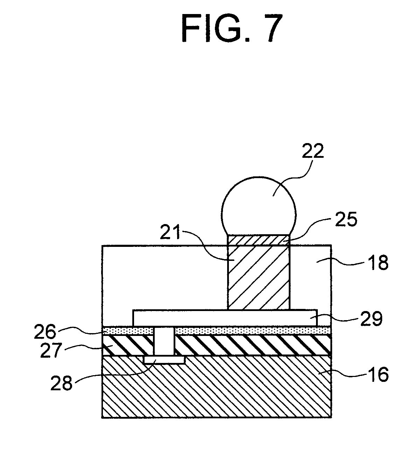

Figs. 6A-6H are cross-sectional views showing a flow of process steps for producing a CSP semiconductor device, using the present photo-curable resin composition, and Fig. 7 is a partly enlarged cross-sectional view of CSP21 in Fig. 6H.

One embodiment of the present invention as applied to CSP will be described below, referring to Figs. 6A-6H.

To wafer 16, 30 cm in diameter, with circuit components formed thereon as shown in Fig. 6A was applied resin composition 18 of Example 2, followed by drying (Fig. 6B). Then, the resin composition was irradiated with light at 1,500 mJ/cm² through a mask as shown in Fig. 6C, where the mask was so positioned as to form vias 20 above pads 17 consisting of copper wiring on wafer 16, not shown here, (but 27 in Fig. 7). Successively, the resin composition was heated at 120°C for 15 minutes and then non-irradiated parts were removed by a developing solution, followed by conducting curing reaction at 140°C for 30 minutes and 180°C for 180 minutes in the same manner as in Example 2, thereby obtaining the wafer with an arrangement of vias 20 as shown in Fig. 6D. Then, copper posts 21 were formed by electrolytic copper plating (Fig. 6E), and barrier metals, not shown here (but 25 in Fig. 7) were formed by Ni plating, and solder balls 22 were formed thereon (Fig. 6F). As shown in Fig. 6G chips were divided one from another by diamond blade 23 to form chip size packages. Thus, CSP (chip size package) 24 as shown in Fig. 6H was finally obtained.

According to the present embodiment, CSP of wafer size can be prepared without removal of plating resist, filling of sealing resin and grinding of sealing resin, resulting in material cost reduction and process simplification.

A package was prepared from CSP thus prepared and the wiring board of Example 9 in the same manner as in Example 9, and subjected to a temperature cycle test in the same manner as in Example 8. No abnormality of electric signals was found at 3,000 cycles in this Example. In Fig. 7 numeral 26 shows polyimide, 27 SiN, 28 Al electrode and 29 wiring layer.

### Comparative Example 12

CSP was prepared in the same manner as in Example 12, except that photo-curable resin of Comparative Example 2 was used. A package was prepared from CSP thus prepared and the wiring board of Example 9 in the same manner as in Example 9 and subjected to a temperature cycle test in the same manner as in Example 8. It was found that electric signals were no more conducted at 300 cycles.

It is obvious from comparison of Example 10 with Comparative Example 12 that reliability of CSP can be considerably increased when prepared by using the present photo-curable resin composition.

According to the present invention, cured products of the present photo-curable resin composition can maintain a desired modulus of elasticity at temperatures as high as or higher than Tg witghout any decrease in the bonding strength at elevated temperatures and without any decrease in resolution due to light scattering because of uniform distribution at the molecular level of organic silicic compound having thermodynamically stable Si-O-Si bonds. The present photo-curable resin composition is applicable to printed wiring boards or CSPs requiring fine pattern formation without any development of inconveniences such as cracks, peeling, etc., contributing to considerable improvement of reliability of electronic appliances using the wiring boards at CSPs.

## Claims

1. A photo-curable resin composition capable of undergoing polymerization and curing by absorption of actinic ray, at least one portion of the resin composition comprising an organic silicic compound represented by the following formula (1) or (2): 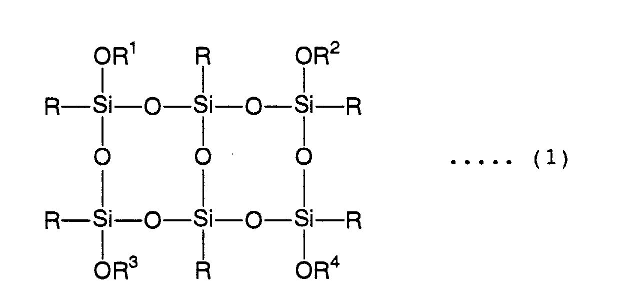 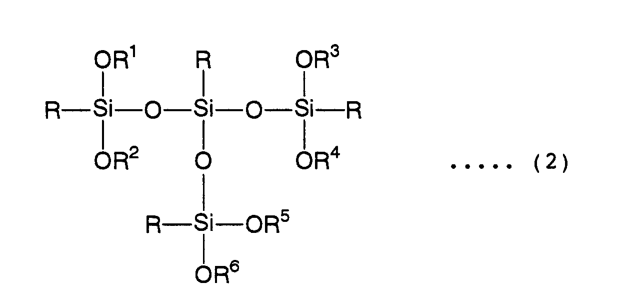 where R is an organic group reacting with an epoxy group; and R¹ to R⁶ are independently silicon-containing groups having 0-3 repeat units of (SiRO_{3/2}); in case the unit of (SiRO_{3/2}) is zero, R¹ to R⁶ are independently H, CH₃ or C₂H₆, an epoxy resin and a photo initiator capable of initiating polymerization of the organic silicic compound or the epoxy resin upon absorption of actinic ray.

2. A photo-curable resin composition according to Claim 1, wherein the organic silicic compound is 3-glycidoxytrimethoxysilane or 3-aminopropyltriethoxysilane, the epoxy resin is bisphenol A epoxy resin, o-cresol novolak epoxy resin or an alicyclic epoxy resin, and the photo initiator is triallylsulfonium hexafluorophosphate.

3. A photo-curable resin composition according to Claim 1, wherein said resin composition provides a cured product having a difference in storage modulus of elasticity at TG + 40°C and 25°C of -1.25 to 1.8 GPa and a difference in bonding strength at Tg + 40°C and 25°C of -0.4 to -0.8 kN/m.

4. A photo-curable resin composition according to Claim 3, wherein the cured product has at Tg + 40°C a storage modulus of elasticity of 0.4 to 0.55 GPa and a bonding strength of 0.7 to 0.9 kN/m.

5. A process for producing a photo-curable resin composition, which comprises a step of heat treating a mixture comprising epoxy resin, an organic silicic compound represented by the following formula (3): 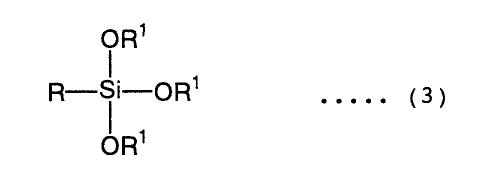 where R is an organic group reacting with an epoxy group; and R¹ is CH₃ or C₂H₅, and water, and a step of mixing a photo initiator with the heat-treated mixture.

6. A process according to Claim 5, wherein the organic silicic compound is 3-glycidoxytrimethoxysilane or 3-aminopropyltriethoxysilane, the epoxy resin is bisphenol A epoxy resin, o-cresol novolak epoxy resin or an alicyclic epoxy resin, and the photo initiator is triallylsulfonium hexafluorophosphate.

7. A process for using the photo-curable resin composition of Claim 1 as an insulating layer in a multilayer wiring board.

8. A process for using the photo-curable resin composition of Claim 1 as a layer for covering projecting electrodes in a semiconductor device.

9. A multilayer wiring board, which comprises conductor layers, insulating layers composed of photo-curable resin composition and formed between the conductor layers and a filler filled in blind via holes interconnecting the conductor layers one to another, wherein at least one of the insulating layers is formed from a photo-curable resin composition, which comprises an organic silicic compound represented by the following general formula (1) or (2): 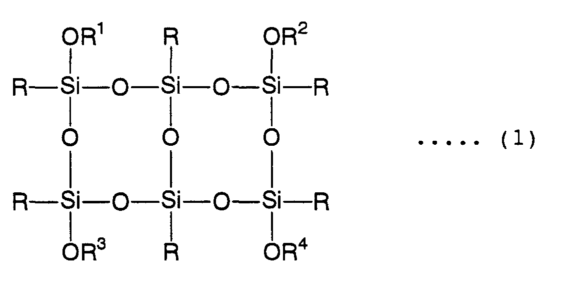 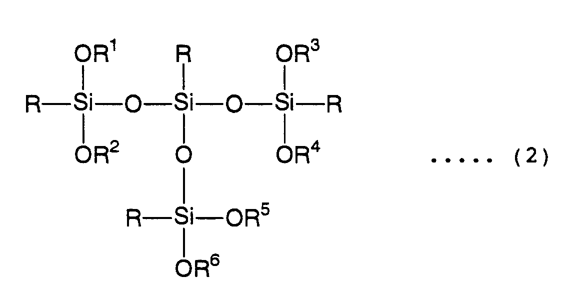 where R is an organic group reacting with an epoxy group; and R¹ to R⁶ are independently silicon-containing groups having 0-3 repeat units of (SiRO_{3/2}); in case the unit of (SiRO_{3/2}) is zero, R¹ to R⁶ are independently H, CH₃ or C₂H₆, an epoxy resin and a photo initiator capable of initiating polymerization of the organic silicic compound or the epoxy resin upon absorption of actinic ray.

10. A multilayer wiring board according to Claim 9, wherein the organic silicic compound is 3-glycidoxytrimethoxysilane or 3-aminopropyltriethoxysilane, the epoxy resin is bisphenol A epoxy resin, o-cresol novolak epoxy resin or an alicyclic epoxy resin, and the photo initiator is triallylsulfonium hexafluorophosphate.

11. A semiconductor device, which comprises a semiconductor component having a projected electrode on the surface, a resin composition covering the projected electrode and a ball electrode connected to the projected electrode exposed from the resin composition, wherein the resin composition is a photo-curable resin composition, which comprises an organic silicic compound represented by the following formula (1) or (2): 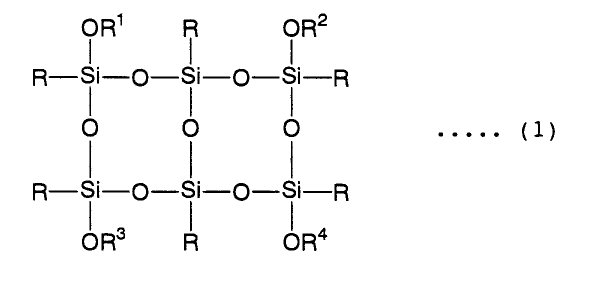 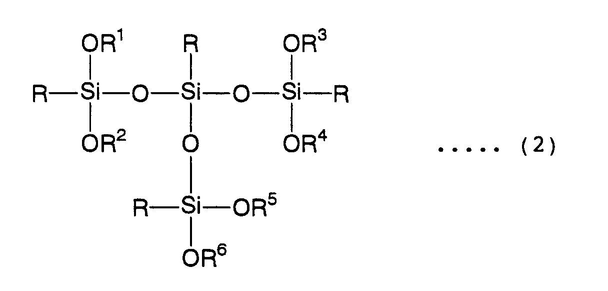 wherein R is an organic group reacting with an epoxy group; and R¹ to R⁶ are independently silicon-containing groups having 0-3 repeat units of (SiRO_{3/2}); in case the unit of (SiRO_{3/2}) is zero, R¹ to R⁶ are independently H, CH₃ or CH₂CH₃, an epoxy resin and a photo initiator capable of initiating polymerization of the organic silicic compound or the epoxy resin upon absorption of actinic ray.

12. A semiconductor device according to Claim 11, wherein the organic silicic compound is 3-glycidoxytrimethoxysilane or 3-aminopropyltriethoxysilane, the epoxy resin is bisphenol A epoxy resin, o-cresol novolak epoxy resin or an alicyclic epoxy resin, and the photo initiator is triallylsulfonium hexafluorophosphate.
